# EUROPÄISCHE PATENTSCHRIFT

(11) **EP 2 348 139 B1**
(45) Veröffentlichungstag und Bekanntmachung des Hinweises auf die Patenterteilung: **06.05.2015**
(21) Anmeldenummer: 11151844.5
(22) Anmeldetag: 24.01.2011
(51) Int. Cl.: C23C 14/50, C23C 16/458, F16H 21/14

(54) **Substratteller und Beschichtungsanlage zum Beschichten von Substraten**
Substrate plate and coating assembly for coating substrates
Plaque de substrat et installation de revêtement destinées au revêtement de substrats

(30) Priorität: 26.01.2010 DE 102010001218
(43) Veröffentlichungstag der Anmeldung: 27.07.2011
(73) Patentinhaber: Esser, Stefan, 52072 Aachen (DE)
(72) Erfinder: Esser, Stefan, 52072 Aachen (DE)
(74) Vertreter: Bauer, Dirk

(56) Entgegenhaltungen:
- EP-A1- 2 048 263
- WO-A1-2007/025397
- DE-A1- 10 337 732
- DE-A1- 19 803 278
- US-A- 5 324 240
- US-A- 6 083 322

## Beschreibung

Die Erfindung betrifft zum Einen einen Substratteller mit einer Mehrzahl von Substrataufnahmen zum Haltern jeweils eines Substrats, wobei jede Substrataufnahme an dem Substratteller um jeweils eine Substratachse rotierbar gelagert ist und mit einem Getriebe, das ein exzentrisches Antriebselement und ein von dem Antriebselement auf einer Kreisbahn um eine Tellerachse des Substrattellers führbares Überträgerelement aufweist und das die Substrataufnahmen antreibt. Weiterhin betrifft die Erfindung eine Beschichtungsanlage zum Beschichten von Substraten, mit einem Kammerboden und einer Mehrzahl von auf dem Kammerboden rotationssymmetrisch um eine Achse der Beschichtungsanlage angeordneten Stützwellen.

Um den CO₂-Ausstoß moderner Motoren zu verringern werden immer mehr Bauteile mit reibungsarmen Verschleißschutzschichten beschichtet. Beschichten ist nach DIN 8580 ein Fertigungsverfahren zum Aufbringen einer festhaftenden Schicht aus formlosem Stoff auf die Oberfläche eines Werkstückes. Ein zu beschichtendes Werkstück wird in der Beschichtungstechnik als "Substrat" benannt. Viele Substrate (insbesondere Motorenbauteile wie Düsennadeln oder Steuerkolben) sind sehr klein, stellen aber zugleich hohe Anforderungen an die Gleichmäßigkeit der Beschichtung: Oft wird verlangt, dass weniger als 0,3 ppm der Teile einen "Drehfehler" aufweisen.

Zum Beschichten kleiner, hochpräziser Substrate kommen insbesondere die physikalische Gasphasenabscheidungs ("physical vapor deposition"/"PVD") und die plasmaunterstützte chemische Gasphasenabscheidung ("plasma enhanced chemical vapor deposition"/"PECVD") zum Einsatz. Im PVD-Verfahren ist das "Target" die Platte, die mit geladenen Teilchen beschossen wird. Dadurch wird Targetmaterial verdampft und im Vakuum, typischer Weise zwischen 10 mPa und 3000 mPa als Schicht auf den relativ kalten Substraten abgeschieden. Häufig wird die Verdampfung durch eine elektrische Entladung herbeigeführt. Hier unterscheidet man die Elektronenstrahlverdampfung (EBPVD electron beam) die Lichtbogenverdampfung (AIP arc ion plating) und die Sputterverfahren (MSIP magnetron sputter ion plating).

Häufig wird auch die Abscheidung durch eine an die Substrate angelegte Spannung beeinflusst. Diese Spannung wird Biasspannung genannt und sie beeinflusst die Schichteigenschaften, insbesondere die Härte der Schicht. Die Biasspannung kann eine Gleichspannung (DC), eine Wechselspannung (AC, MF, RF) oder eine gepulste Spannung (Unipolar, Bipolar) sein.

Im PECVD Verfahren wird das Schichtmaterial gasförmig der Beschichtungskammer zugeführt. An die Substrate wird eine RF oder gepulste Spannung angelegt, die das Gas aufspaltet und zur Abscheidung eines Teils führt. Das Vakuum beim PECVD liegt üblicherweise um Faktor 10 bis 100 höher als beim PVD.

Allen PVD-Verfahren gemeinsam ist, dass das Schichtmaterial sich überwiegend geradlinig von der Quelle ausbreitet bzw. teilweise von den elektrischen Feldlinien abgelenkt wird. Hierdurch entstehen in der Ausbreitung des Schichtmaterials Vorzugsrichtungen, so dass Substratflächen, die entgegen dieser Vorzugsrichtungen orientiert sind, eine besonders hohe Abscheiderate aufweisen. Substratflächen, die den Vorzugsrichtungen abgewandt sind, werden kaum beschichtet. Um eine homogene Beschichtung der einzelnen Substrate zu erzielen, werden diese in der Beschichtungskammer um mehrere Achsen gesteuert rotiert.

In allgemein bekannten Beschichtungsanlagen für diese Verfahren werden die Substrate auf angepassten Substrataufnahmen vereinzelt. Jeweils bis 100 Substrataufnahmen sind auf Substrattellern angeordnet, die auf einem Tisch einzeln oder übereinander gestapelt um eine Tellerachse rotieren. Allgemein bekannte Beschichtungsanlagen weisen einen Durchmesser von 30 bis 150 cm auf und fassen typischer Weise sechs bis 18 Tische auf einem Kammerboden zusammen. Die Tische werden von einem gemeinsamen zentralen Antrieb des Kammerbodens über ein Antriebsrad angetrieben.

Allgemein bekannte Substratteller weisen ein Getriebe auf, über das die Substrataufnahmen des Substrattellers angetrieben werden. Jede Substrataufnahme eines solchen bekannten Substrattellers weist ein Antriebsrad auf, das in einer Substratachse unmittelbar von einem außenverzahnten Sonnenrad des Substrattellers und dieses unmittelbar durch das Antriebsrad des Kammerbodens angetrieben wird. In einer Variante dieses bekannten Substrathalters ist der Antrieb der Substrataufnahmen kinematisch umgekehrt: Das Antriebsrad des Kammerbodens treibt das außenverzahnte Gehäuse des Substrattellers, an wobei das Sonnenrad des Substrattellers mit dem Kammerboden verdrehfest verbunden ist.

Um die Drehzahl eines Substrats um seine Substratachse zu begrenzen, muss in diesen bekannten Substrathaltern das Umfangsverhältnis von Sonnenrad und Antriebsrad begrenzt werden: Die Antriebsräder der einzelnen Substrathalter dürfen also nicht allzu klein sein. Da andererseits der Radius der Antriebsräder den Abstand zum nächsten Substrathalter begrenzt, sind die bekannten Substrathalter nur für vergleichsweise kleine Substratteller mit wenigen Substraten nutzbar.

Um die Drehzahl der Substrate zu vermindern, hat der Erfinder in EP 2 048 263 einen Substratteller der einleitend genannten Art offenbart: Das Getriebe weist ein exzentrisches Antriebselement auf, das ein Zahnrad auf einer Kreisbahn um ein Zentralrad in der Tellerachse des Substrattellers führt. Das Zahnrad treibt zum Einen eine Rotation des Substrattellers mit den Substrataufnahmen um die Tellerachse an. Zum Andern bewegt das Zahnrad ein relativ zu dem Substratteller nicht rotierendes Überträgerelement gleichfalls auf einer Kreisbahn um die Tellerachse. Die Substrataufnahmen werden synchron mit der Relativbewegung des Antriebselements zu Substratteller und Überträgerelement über Kurbeltriebe in der Substratachse von dem Überträgerelement angetrieben. Durch Auswahl passender Umfangsgrößen des Zentralrads, des umlaufenden Zahnrads und der Innenverzahnung des Überträgerelements kann die Übersetzung zwischen Antrieb und Überträgerelement in dem bekannten Substrathalter in weiten Grenzen variiert und an die technischen Erfordernisse zur Beschichtung der jeweiligen Substrate angepasst werden. Die bekannten Substratteller benötigen zwei unterschiedliche Drehgeschwindigkeiten. Dies ist insbesondere beim Stapeln der Teller übereinander nachteilig, da man von Ebene zu Ebene zwei Kupplungen verbinden muss.

Patentdokument WO2007/025397 offenbart einen Werkstückträger mit einem Drehgestell. Aufgabe Der Erfindung liegt die Aufgabe zugrunde, die Nachteile des bekannten Standes der Technik zu vermeiden.

### Lösung

Ausgehend von den bekannten Substrattellern wird nach der Erfindung gemäß Anspruch 1 vorgeschlagen, dass das Überträgerelement ein Zahnrad ist, das an einer Mehrzahl von parallel zur Tellerachse verlaufenden, mit dem Substratteller verbundenen Bolzen abgestützt ist, über ein Sonnenrad die Substrataufnahmen antreibt und eine zentrale Bohrung aufweist, in der als Antriebselement eine exzentrisch zu der Tellerachse angeordnete Kreisscheibe gleitet. Das Getriebe des erfindungsgemäßen Substrattellers ist ein Zykloidgetriebe aus der Gruppe der Exzentergetriebe, in dem eine Kreisscheibe um eine Exzentrizität E gegenüber einer Antriebsachse versetzt exzentrisch rotiert. Die Kreisscheibe treibt ein Zahnrad an, das auf einer mit der Antriebsachse koaxialen Innenverzahnung abwälzt. Das Zahnrad weist Bohrungen auf, in denen es auf Bolzen abgestützt ist. Diese Bohrungen weisen einen um den doppelten Betrag der Exzentrizität E größeren Durchmesser auf als die Bolzen. Der Abtrieb des Zykloidgetriebes kann entweder mit der Innenverzahnung oder mit den Bolzen, der jeweils andere Teil des Getriebes mit dem Gehäuse verbunden sein: Ist - wie in der Erfindung - der Abtrieb mit der Innenverzahnung und das Gehäuse mit den Bolzen verbunden, so rotieren An- und Abtrieb gleichsinnig, andernfalls gegensinnig. Je Umdrehung des Antriebselements bewegt sich der Abtrieb - hier: das Sonnenrad - um einen von der Exzentrizität E abhängigen Kreisbogen weiter: je kleiner die Exzentrizität, desto höher ist die Untersetzung des Getriebes und desto langsamer rotiert der Abtrieb gegenüber dem Antrieb. Das Getriebe des erfindungsgemäßen Substrattellers weist - außer An- und Abtrieb - mit dem Zahnrad nur ein einziges weiteres bewegtes Bauteil auf.

An einem erfindungsgemäßen Substratteller können die Substratachsen - insbesondere bei Verwendung von Kegelrädern für das Sonnenrad und für die Antriebsräder der Substratachsen - gegenüber der Tellerachse nahezu beliebig geneigt sein. Ein solcher erfindungsgemäßer Substratteller kann spezielle Anforderungen an die Beschichtung erfüllen. Alternativ können die Substratachsen parallel zu der Tellerachse verlaufen. Ein solcher erfindungsgemäßer Substratteller zeichnet sich durch einfache - und damit preisgünstige herzustellende - Verzahnungen am Sonnenrad und an den Antriebsrädern der Substrataufnahmen aus.

Vorzugsweise weist ein erfindungsgemäßer Substratteller eine in der Tellerachse verlaufende Welle auf, die ein Passelement zur verdrehfesten Verbindung mit einer Stützwelle einer Beschichtungsanlage aufweist. Beschichtungsanlagen mit derartigen Stützwellen für Substratteller sind allgemein bekannt. In der Beschichtungsanlage können solche erfindungsgemäßen Substratteller übereinander auf die Stützwelle geschoben und aufeinander abgestützt werden.

An einem erfindungsgemäßen Substratteller ist besonders bevorzugt das Antriebselement mit einem radial über die Substrataufnahmen hinausweisenden Stützhebel verbunden.

Beschichtungsanlagen mit einem oder mehreren angetriebenen Tellern für die Substratteller, die seitlich neben dem Teller einen parallel zur Tellerachse verlaufenden Stützstab aufweisen, sind allgemein bekannt. An diesem Stützstab stützen sich die Substratteller mit einem Stützhebel ab, um die Rotation des Tellers in das Getriebe zum Antrieb der Substrataufnahmen einzuleiten.

Beim Einsatz aller bekannten Substratteller in den bekannten Beschichtungsanlagen sind Störungen praktisch nicht zu vermeiden: Schon allein die Vielzahl bewegter Bauteile in jedem Substratttisch und deren Verschleiß und Verformung unter den typischer Weise hohen Betriebstemperaturen führt gelegentlich zu Blockaden im Getriebe. Hinzu kommt, dass das Getriebe des Substrattellers - wiederum wegen der hohen Betriebstemperaturen - weder im Betrieb geschmiert, noch gegenüber der Beschichtungskammer hermetisch abgedichtet werden kann. Verunreinigungen - insbesondere Partikel des schichtbildenden Materials - dringen in das Getriebe ein und blockieren gleichfalls dessen Bewegung. Bei einem solchen Fehlerfall - einem sogenannten "Drehfehler" - kommen mit dem Getriebe des betroffenen Substrattellers auch dessen Substrataufnahmen zum Stillstand und werden nicht mehr gleichmäßig beschichtet.

Vorteilhafter Weise ist als Überlastsicherung an einem erfindungsgemäßen Substratteller mit Stützhebel dieser mit dem Antriebselement nur bis zu einem Überlastmoment verdrehfest verbunden. Wird bei einem Drehfehler das Überlastmoment eines Substrattellers überschritten, so ist die Verbindung des Stützhebels mit dem Antriebselement nicht mehr verdrehfest und das Antriebselement nicht mehr über den Stützhebel an dem Stützstab abgestützt, also von dem Antrieb der Beschichtungsanlage entkoppelt und hindert weder die Anlage als Ganzes, noch die anderen Substratteller an der Vollendung des Beschichtungsvorgangs. Der Stützhebel kann hierzu besonders einfach durch eine zur Tellerachse parallele Schraubverbindung mit definierter Klemmkraft mit dem Antriebselement verbunden sein. Eine genauere Bestimmung des Überlastmoments erlaubt alternativ eine federbelastete Halterung des Stützhebels an dem Antriebselement.

Besonders bevorzugt verbleibt der Stützhebel als Überlastanzeige nach einem Fehlerfall in einer von dem Stützstab entkoppelten Position. In der Beschichtungsanlage muss ein Drehfehler bei der Rotation der Substrate deutlich angezeigt werden, damit die entsprechenden Substrate ausgesondert werden können. Nach einem Beschichtungsvorgang kann der Bediener der Beschichtungsanlage besonders einfach durch Sichtkontrolle den Fehlerfall eines solchen erfindungsgemäßen Substrattellers feststellen und die Substrate des betroffenen Substrattellers aussondern. Ein federbelasteter Stützhebel kann bei Überschreiten des Überlastmoments beispielsweise über einen Punkt hinaus um einen Lagerpunkt verdreht werden, in dem die Feder diesen Lagerpunkt überstreicht. Eine solche Überlastsicherung und Drehfehleranzeige kann nicht nur in einem erfindungsgemäßen, sondern auch in jedem anderen, allgemein bekannten Substratteller zum Einsatz kommen.

Ein erfindungsgemäßer Substratteller weist vorzugsweise eine Schutzhülse auf, die den Substratteller seitlich umschließt, wobei die Schutzhülse Bohrungen aufweist und die Substrataufnahmen die Schutzhülse in den Bohrungen durchdringen. Substratteller mit solchen Schutzhülsen sind allgemein bekannt. Die Schutzhülse vermeidet das Eindringen des Materials der Beschichtung in die Mechanik des Substrattellers, insbesondere in das Getriebe zum Antrieb der Substrataufnahmen.

Ausgehend von den bekannten Beschichtungsanlagen wird erfindungsgemäß vorgeschlagen dass auf mindestens einer der Stützwellen mindestens ein erfindungsgemäßer Substratteller angeordnet ist. Eine solche erfindungsgemäße Beschichtungsanlage zeichnet sich durch die vorstehend beschriebenen Vorteile des erfmdungsgemäßen Substrattellers aus.

In einer erfindungsgemäßen Beschichtungsanlage ist bevorzugt auf einer Welle eines erfindungsgemäßen Substrattellers ein weiterer Substratteller abgestützt. In einer solchen erfindungsgemäßen Beschichtungsanlage wird die Last des weiteren Substrattellers über die Welle durch das Getriebe und den erfindungsgemäßen Substratteller hindurch in den Teller der Beschichtungsanlage geleitet. Eine eventuell vorhandene Schutzhülse des erfindungsgemäßen Substrattellers hat für den weiteren Substratteller keine tragende Funktion und kann entsprechend leicht gebaut werden.

In einer erfindungsgemäßen Beschichtungsanlage sind vorteilhafter Weise die Stützwelle um ihre Längsachse antreibbar und erfindungsgemäße Substratteller, die eine in der Tellerachse verlaufende Welle, und ein Passelement zur verdrehfesten Verbindung mit einer Stützwelle einer Beschichtungsanlage aufweisen, sind mit der Stützwelle verdrehfest verbunden.

Weiterhin weist in einer solchen erfindungsgemäßen Beschichtungsanlage besonders bevorzugt mindestens einer der erfindungsgemäßen Substratteller ein Antriebselement mit einem radial über die Substrataufnahmen hinausweisenden Stützhebel auf, wobei der Stützhebel des Substrattellers an einem parallel zu der Stützwelle verlaufenden, mit dem Kammerboden verbundenen Stützstab abgestützt ist.

### Ausführungsbeispiele

Die Erfindung wird nachfolgend anhand von Ausführungsbeispielen erläutert. Es zeigen
- Fig. 1a: einen ersten erfindungsgemäßer Substratteller,
- Fig. 1b: das Getriebe des erfindungsgemäßen Substrattellers in einer Detailansicht,
- Fig. 2: eine erste erfindungsgemäße Beschichtungsanlage,
- Fig. 3: eine zweite erfindungsgemäße Beschichtungsanlage,
- Fig. 4: eine dritte erfindungsgemäße Beschichtungsanlage und
- Fig. 5: eine vierte erfindungsgemäße Beschichtungsanlage.
- Fig. 6: eine fünfte erfindungsgemäße Beschichtungsanlage

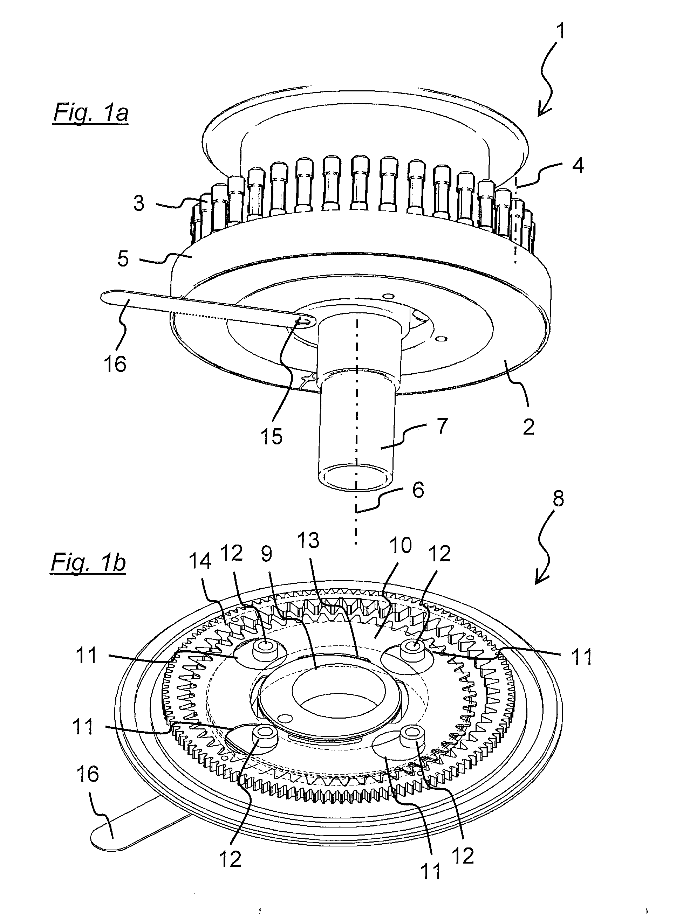

Der in Figur 1a gezeigte erste erfindungsgemäße Substratteller 1 weist auf einer Grundplatte 2 (nicht dargestellte) 36 Substrataufnahmen mit jeweils einer Hülse 3 zum Einstecken jeweils eines (gleichfalls nicht dargestellten) Substrats auf. Jede Substrataufnahme ist an der Grundplatte 2 um eine Substratachse 4 rotierbar gelagert.

Der Substratteller 1 weist eine Schutzhülse 5 auf, die die Grundplatte 2 seitlich umschließt.

Die Schutzhülse 5 weist (nicht dargestellte) Bohrungen auf, in denen die Substrataufnahmen die Schutzhülse 5 durchdringen. Darüber hinaus weist der Substratteller 1 eine mit der Grundplatte 2 verbundene, in der Tellerachse 6 verlaufende Welle 7 auf, mit der die Grundplatte 2 auf einer rotierbaren Stützwelle einer Beschichtungsanlage gelagert werden kann. Die Welle 7 weist im Innern ein Passelement zur verdrehfesten Verbindung mit der Stützwelle auf. Das Passelement und die Beschichtungsanlage mit der Stützwelle sind nicht dargestellt. In der Beschichtungsanlage wird durch die Rotation der Stützwelle über die Welle 7 auch die Grundplatte 2 mit den Substrataufnahmen und der Schutzhülse 5 in Rotation um die Stützwelle versetzt.

Weiterhin weist der Substratteller 1 ein in Figur 1b im Detail gezeigtes Getriebe 8 mit einer um die Tellerachse 6 exzentrisch rotierbar gelagerten Kreisscheibe als Antriebselement 9 und einem Zahnrad mit 53 Zähnen als Überträgerelement 10 auf. Die Kreisscheibe 9 weist einen Durchmesser von ca. 40 mm auf. Das Zahnrad 10 ist in vier Bohrungen 11 an je einem parallel zur Tellerachse 6 verlaufenden, mit der Grundplatte 2 verbundenen Bolzen 12 radial abgestützt und weist eine zentrale Bohrung 13 auf, in der die Kreisscheibe 9 gleitet. Das Zahnrad 10 wird so von der Kreisscheibe 9 auf einer (nicht dargestellten) Kreisbahn um die Tellerachse 6 des Substrattellers 1 gerührt, hierbei aber gegenüber der Grundplatte 2 nicht um die Tellerachse 6 verdreht. Das Zahnrad 10 versetzt ein auf der Grundplatte 2 um die Tellerachse 6 rotierbar gelagertes, innen mit 57 Zähnen und außen mit 121 Zähnen verzahntes Sonnenrad 14 in Rotation. Das Sonnenrad 14 treibt über (nicht dargestellte) mit den Substrataufnahmen verdrehfest verbundene Antriebsräder die Substrataufnahmen an.

Die Kreisscheibe 9 ist durch eine Schraubverbindung 15 mit einem radial über die Substrataufnahmen und die Schutzhülse 5 hinausragenden Stützhebel 16 verbunden. Bei Überschreiten eines Überlastmoments an dem Stützhebel 16 klappt dieser um die Schraubverbindung 15 aus seiner radialen Stellung ein. Damit verlieren das Getriebe 8 des Substrattellers 1 und mit diesem die Substrataufnahmen ihren Antrieb und beenden ihre Bewegung gegenüber dem (um die Tellerachse 6 rotierenden) Substratteller 1.

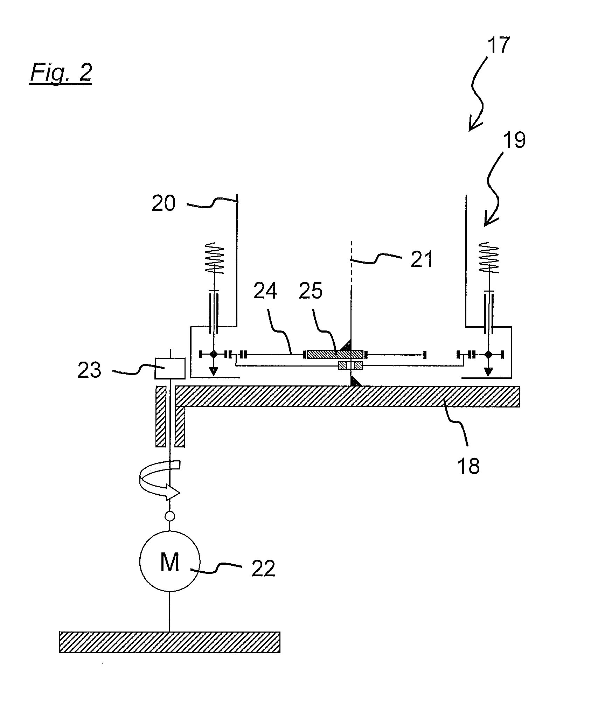

Die in Figur 2 in einer Prinzipskizze gezeigte erste erfindungsgemäße Beschichtungsanlage 17 trägt auf einem Kammerboden 18 einen zweiten erfindungsgemäßen Substratteller 19. Dieser Substratteller 19 unterscheidet sich von dem ersten Substratteller 1 aus den Figuren 1a und 1b insofern, als die Schutzhülse 20 eine (nicht dargestellte) Außenverzahnung und die (gleichfalls nicht dargestellte) Welle kein Passelement zur verdrehfesten Verbindung mit der Stützwelle 21 des Kammerbodens 18 aufweist. Ein mittels eines Motors 22 angetriebenes Antriebsrad 23 des Kammerbodens 18 greift in die Außenverzahnung der Schutzhülse 20 ein und rotiert mit dieser die (nicht dargestellte) Grundplatte, die (gleichfalls nicht dargestellten) Bolzen und das Zahnrad 24 um die Stützwelle 21. Der zweite Substratteller 19 weist auch keinen Stützhebel auf. Stattdessen ist die Kreisscheibe 25 des zweiten Substrattellers 19 mit der Stützwelle 21 und diese mit dem Kammerboden 18 der Beschichtungsanlage 17 verdrehfest verbunden.

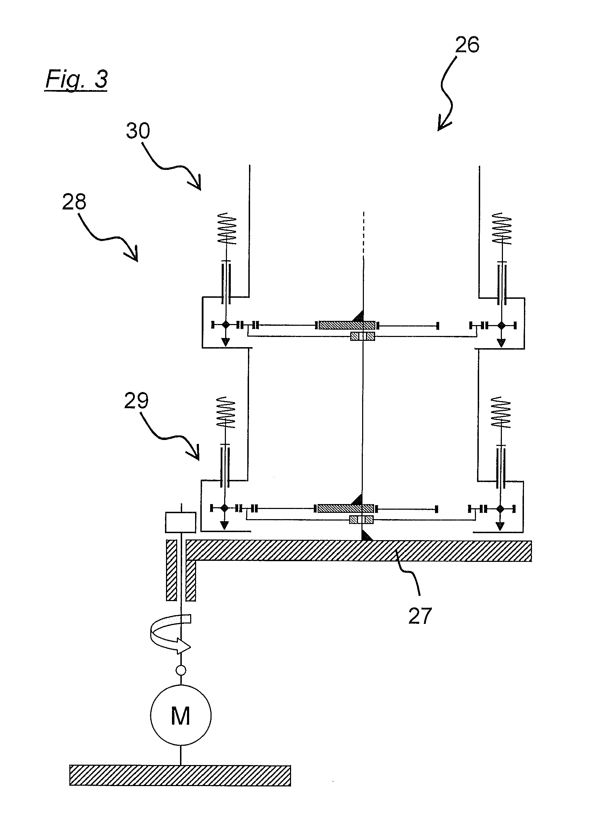

Die in Figur 3 in einer Prinzipskizze gezeigte zweite erfindungsgemäße Beschichtungsanlage 26 unterscheidet sich von der ersten Beschichtungsanlage 17 aus Figur 2 lediglich insofern, als sie auf dem Kammerboden 27 einen Stapel 28 aus einem mit dem zweiten Substratteller 19 identischen unteren Substratteller 29 und einem weiteren identischen oberen Substratteller 30 trägt. Die (in Figur 3 nicht dargestellte) Welle des oberen Substrattellers 30 ist auf den (gleichfalls in Figur 3 nicht dargestellten) Bolzen des unteren Substrattellers 29 abgestützt. Die Schutzhülse 20 des unteren Substrattellers 29 hat so keine tragende Funktion.

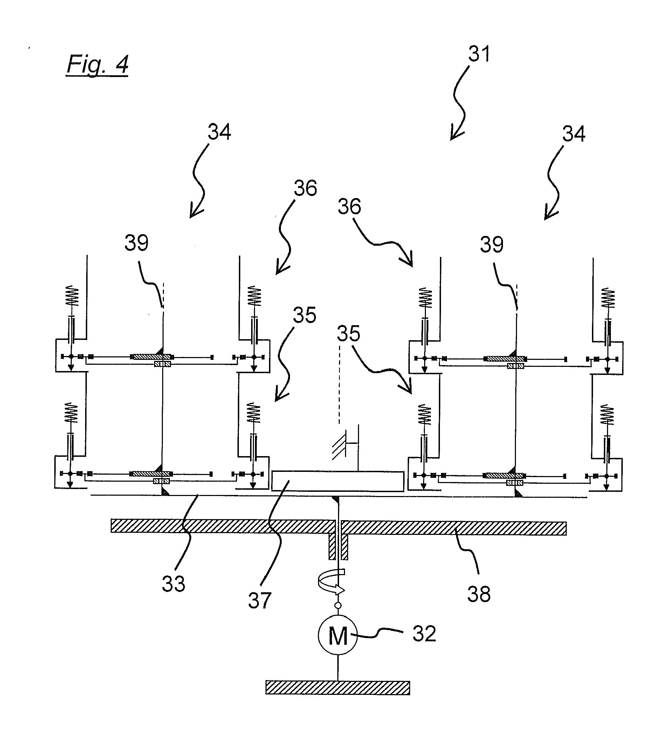

Die in Figur 4 in einer Prinzipskizze gezeigte dritte erfindungsgemäße Beschichtungsanlage 31 unterscheidet sich von der zweiten Beschichtungsanlage 26 aus Figur 3 lediglich insofern, als von dem Motor 32 ein Teller 33 angetrieben wird, der nicht nur einen, sondern sechs Stapel 34 aus je zwei Substrattellern 35, 36 trägt. Das Sonnenrad 37 der dritten Beschichtungsanlage 31 ist mit dem Kammerboden 38 verdrehfest verbunden und treibt jeweils den unteren Substratteller 35 der Stapel 34 um deren jeweilige Stützwelle 39 an.

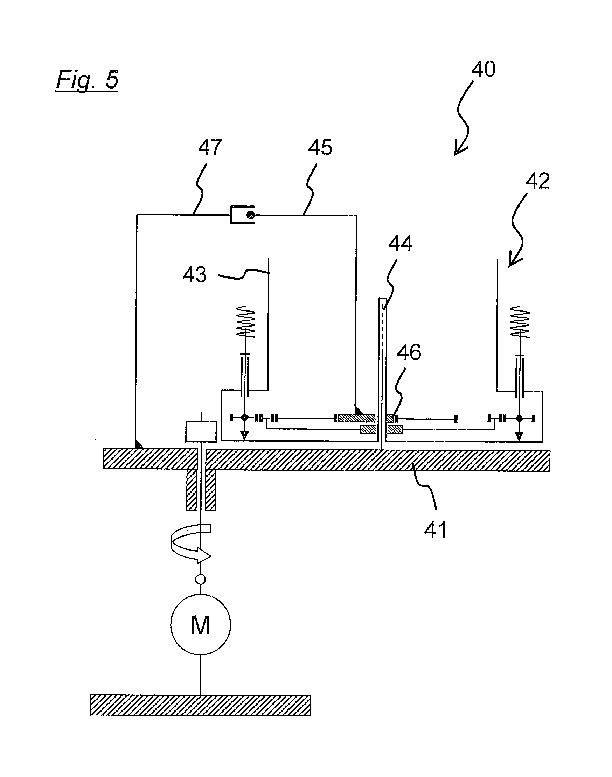

Die in Figur 5 in einer Prinzipskizze gezeigte vierte erfindungsgemäße Beschichtungsanlage 40 trägt auf einem Kammerboden 41 einen dritten erfmdungsgemäßen Substratteller 42. Der Substratteller 42 weist wie der zweite Substratteller 19 aus Figur 2 an der Schutzhülse 43 eine (nicht dargestellte) Außenverzahnung und an der (gleichfalls nicht dargestellten) Welle kein Passelement zur verdrehfesten Verbindung mit der Stützwelle 44 des Kammerbodens 41 auf, unterscheidet sich aber ansonsten nicht von dem ersten Substratteller 1 aus den Figuren 1a und 1 b. Insbesondere weist der dritte Substratteller 42 einen Stützhebel 45 auf. Die vierte Beschichtungsanlage 40 unterscheidet sich von der ersten Beschichtungsanlage 17 aus Figur 2 lediglich insofern, als die Stützwelle 44 an dem Kammerboden 41 rotierbar gelagert ist. Die Kreisscheibe 46 des dritten Substrattellers 42 ist mit dem Stützhebel 45 an einem mit dem Kammerboden 41 fest verbundenen Stützstab 47 abgestützt. Der Stützhebel 45 ist nur bis zu einem Überlastmoment von etwa 0,4 Nm mit der Kreisscheibe 46 verdrehfest verbunden. Stützhebel 45 und der Stützstab 47 wirken so als Überlastkupplung für den Fall eines Drehfehlers.

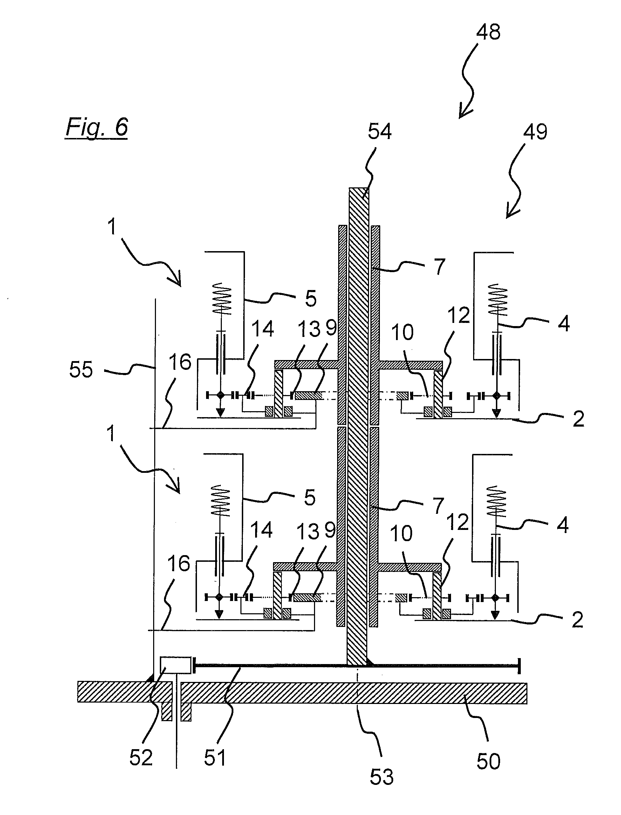

Die in Figur 6 in einer Prinzipskizze gezeigte fünfte erfindungsgemäße Beschichtungsanlage 48 unterscheidet sich von der in Figur 3 gezeigten zweiten erfindungsgemäßen Beschichtungsanlage 26 lediglich insofern, als ein Stapel aus zwei ersten erfindungsgemäßen Substrattellern 1 nicht unmittelbar auf dem Kammerboden 50, sondern auf einem Teller 51 steht, der über ein Sonnenrad 52 der Beschichtungsanlage 48 um die Tellerachse 53 angetrieben wird.

Der Teller 51 weist eine senkrechte Stützwelle 54 auf, auf der die hohlen Wellen 7 der Substratteller 1 verdrehfest gelagert sind. Die Wellen 7 der Substratteller 1 sind senkrecht unmittelbar aufeinander abgestützt, die Schutzhülsen 5 der Substratteller 1 haben keine tragende Funktion. Die Stützhebel 16 der Substratteller 1 sind an einem Stützstab 55 abgestützt, der mit dem Kammerboden 50 der fünften Beschichtungsanlage 48 verschweißt ist.

### In den Figuren sind

- 1: Substratteller
- 2: Grundplatte
- 3: Hülse
- 4: Substratachse
- 5: Schutzhülse
- 6: Tellerachse
- 7: Welle
- 8: Getriebe
- 9: Kreisscheibe/Antriebselement
- 10: Zahnrad/Überträgerelement
- 11: Bohrung
- 12: Bolzen
- 13: Bohrung
- 14: Sonnenrad
- 15: Schraubverbindung
- 16: Stützhebel
- 17: Beschichtungsanlage
- 18: Kammerboden
- 19: Substratteller
- 20: Schutzhülse
- 21: Stützwelle
- 22: Motor
- 23: Antriebsrad
- 24: Zahnrad/Überträgerelement
- 25: Kreisscheibe/Antriebselement
- 26: Beschichtungsanlage
- 27: Kammerboden
- 28: Stapel
- 29: unterer Substratteller
- 30: oberer Substratteller
- 31: Beschichtungsanlage
- 32: Motor
- 33: Teller
- 34: Stapel
- 35: unterer Substratteller
- 36: oberer Substratteller
- 37: Sonnenrad
- 38: Kammerboden
- 39: Stützwelle
- 40: Beschichtungsanlage
- 41: Kammerboden
- 42: Substratteller
- 43: Schutzhülse
- 44: Stützwelle
- 45: Stützhebel
- 46: Kreisscheibe/Antriebselement
- 47: Stützstab
- 48: Beschichtungsanlage
- 49: Stapel
- 50: Kammerboden
- 51: Teller
- 52: Sonnenrad
- 53: Tellerachse
- 54: Stützwelle
- 55: Stützstab

## Patentansprüche

1. Substratteller (1, 19, 29, 30, 35, 36, 42) mit einer Mehrzahl von Substrataufnahmen zum Haltern jeweils eines Substrats, wobei jede Substrataufnahme an dem Substratteller (1, 19, 29, 30, 35, 36, 42) um jeweils eine Substratachse (4) rotierbar gelagert ist und mit einem Getriebe (8), das ein exzentrisches Antriebselement (9, 25, 46) und ein von dem Antriebselement (9, 25, 46) auf einer Kreisbahn um eine Tellerachse (6, 53) des Substrattellers (1, 19, 29, 30, 35, 36, 42) führbares Überträgerelement (10, 24) aufweist und das die Substrataufnahmen antreibt, ***dadurch gekennzeichnet, dass*** das Überträgerelement (10, 24) ein Zahnrad ist, das an einer Mehrzahl von parallel zur Tellerachse (6, 53) verlaufenden, mit dem Substratteller (1, 19, 29, 30, 35, 36, 42) verbundenen Bolzen (12) abgestützt ist, über ein Sonnenrad (14) die Substrataufnahmen antreibt und eine zentrale Bohrung (13) aufweist, in der als Antriebselement (9, 25, 46) eine exzentrisch zu der Tellerachse (6, 53) angeordnete Kreisscheibe gleitet, so dass auf einer in der Tellerachse (6, 53) verlaufenden Welle (7) des Substrattellers (1, 29, 35) ein weiterer Substratteller (1, 30, 36) derart abstützbar ist, dass eine Last des weiteren Substrattellers (1, 30, 36) über die Welle (7) durch das Getriebe (8) und den Substratteller (1, 29, 35) hindurch geleitet wird.

2. Substratteller nach dem vorgenannten Anspruch, ***dadurch gekennzeichnet, dass*** die Substratachsen gegenüber der Tellerachse geneigt sind.

3. Substratteller (1, 19, 29, 30, 35, 36, 42) nach einem der vorgenannten Ansprüche, ***dadurch gekennzeichnet, dass*** die Welle (7) ein Passelement zur verdrehfesten Verbindung mit einer Stützwelle (21, 39, 44, 54) einer Beschichtungsanlage (17, 31, 40, 48) aufweist.

4. Substratteller (1, 42) nach einem der vorgenannten Ansprüche, ***dadurch gekennzeichnet, dass*** das Antriebselement (9, 46) mit einem radial über die Substrataufnahmen hinausweisenden Stützhebel (16, 45) verbunden ist.

5. Substratteller (1, 42) nach dem vorgenannten Anspruch, ***dadurch gekennzeichnet, dass*** der Stützhebel (16, 45) mit dem Antriebselement (9, 46) nur bis zu einem Überlastmoment verdrehfest verbunden ist.

6. Substratteller (1, 19, 29, 30, 35, 36, 42) nach einem der vorgenannten Ansprüche, ***gekennzeichnet durch*** eine Schutzhülse (5, 20, 43), die den Substratteller (1, 19, 29, 30, 35, 36, 42) seitlich umschließt, wobei die Schutzhülse (5, 20, 43) Bohrungen aufweist und die Substrataufnahmen die Schutzhülse (5, 20, 43) in den Bohrungen durchdringen.

7. Beschichtungsanlage (17, 26, 31, 40, 48) zum Beschichten von Substraten, mit einem Kammerboden (18, 27, 38, 41, 50) und mindestens einer auf dem Kammerboden (18, 27, 38, 41, 50) rotationssymmetrisch um eine Achse der Beschichtungsanlage (17, 26, 31, 40, 48) angeordneten Stützwelle (21, 39, 44, 54), wobei auf mindestens einer der Stützwellen (21, 39, 44, 54) mindestens ein erster Substratteller (1, 19, 29, 30, 35, 36, 42) und ein zweiter Substratteller (1, 30, 36) angeordnet ist, ***dadurch gekennzeichnet, dass*** der erste Substratteller (1, 29, 35) nach einem der vorgenannten Ansprüche ausgebildet und auf einer in der Tellerachse (6, 53) verlaufenden Welle (7) des ersten Substrattellers (1, 29, 35) der zweite Substratteller (1, 30, 36) derart abgestützt ist, dass eine Last des zweiten Substrattellers (1, 30, 36) über die Welle (7) durch den ersten Substratteller (1, 29, 35) und sein Getriebe (8) hindurch geleitet wird.

8. Beschichtungsanlage (40, 48) nach dem vorgenannten Anspruch, ***dadurch gekennzeichnet, dass*** die Stützwellen (44, 54) um ihre Längsachse antreibbar und dass Wellen (7) von Substrattellern (1, 42) gemäß Anspruch 3 mit der Stützwelle (44, 54) verdrehfest verbunden sind.

9. Beschichtungsanlage (40, 48) nach dem vorgenannten Anspruch, ***dadurch gekennzeichnet, dass*** auf der Stützwelle (44, 54) mindestens einer der Substratteller (1, 42) gemäß Anspruch 4 ausgestaltet ist, wobei der Stützhebel (16, 44) des Substrattellers (1, 42) an einem parallel zu der Stützwelle (44, 54) verlaufenden, mit dem Kammerboden (41, 50) verbundenen Stützstab (47, 55) abgestützt ist.

## Claims

1. A substrate plate (1, 19, 29, 30, 35, 36, 42) having a plurality of substrate receptacles for holding one substrate in each case, wherein each substrate receptacle is mounted on the substrate plate (1, 19, 29, 30, 35, 36, 42) rotatably about one substrate axis (4) in each case and having a gearbox (8), which has an eccentric drive element (9, 25, 46) and a carrier element (10, 24) which can be guided by the drive element (9, 25, 46) on a circular path about a plate axis (6, 53) of the substrate plate (1, 19, 29, 30, 35, 36, 42) and which drives the substrate receptacles, **characterised in that** the carrier element (10, 24) is a gear wheel, which is supported on a plurality of bolts (12) running parallel to the plate axis (6, 53) and connected to the substrate plate (1, 19, 29, 30, 35, 36, 42), drives the substrate receptacles via a sun gear (14) and has a central bore (13), in which a disc, which is arranged eccentrically to the plate axis (6, 53), slides as drive element (9, 25, 46), so that a further substrate plate (1, 30, 36) can be supported in such a manner on a shaft (7) of the substrate plate (1, 29, 35) running in the plate axis (6, 53) that a load of the further substrate plate (1, 30, 36) is guided through the gearbox (8) and the substrate plate (1, 29, 35) via the shaft (7).

2. The substrate plate according to the preceding claim, **characterised in that** the substrate axes are inclined with respect to the plate axis.

3. The substrate plate (1, 19, 29, 30, 35, 36, 42) according to one of the preceding claims, **characterised in that** the shaft (7) has a fitting element for rotationally fixed connection to a support shaft (21, 39, 44, 54) of a coating plant (17, 31, 40, 48).

4. The substrate plate (1, 42) according to one of the preceding claims, **characterised in that** the drive element (9, 46) is connected to a support lever (16, 45) reaching radially beyond the substrate receptacles.

5. The substrate plate (1, 42) according to the preceding claim, **characterised in that** the support lever (16, 45) is connected to the drive element (9, 46) in a rotationally fixed manner only up to an overload torque.

6. The substrate plate (1, 19, 29, 30, 35, 36, 42) according to one of the preceding claims, **characterised by** a protective sleeve (5, 20, 43), which laterally encloses the substrate plate (1, 19, 29, 30, 35, 36, 42), wherein the protective sleeve (5, 20, 43) has bores and the substrate receptacles penetrate the protective sleeve (5, 20, 43) in the bores.

7. A. coating plant (17, 26, 31, 40, 48) for coating substrates, having a chamber bottom (18, 27, 38, 41, 50) and at least one support shaft (21, 39, 44, 54), arranged on the chamber bottom (18, 27, 38, 41, 50) rotationally symmetrically about an axis of the coating plant (17, 26, 31, 40, 48), wherein at least one first substrate plate (1, 19, 29, 30, 35, 36, 42) and one second substrate plate (1, 30, 36) are arranged on at least one of the support shafts (21, 39, 44, 54), **characterised in that** the first substrate plate (1, 29, 35) is constructed according to one of the preceding claims and the second substrate plate (1, 30, 36) is supported on a shaft (7) of the first substrate plate (1, 29, 35) running in the plate axis (6, 53) in such a manner that a load of the second substrate plate (1, 30, 36) is guided through the first substrate plate (1, 29, 35) and the gearbox (8) thereof via the shaft (7).

8. The coating plant (40, 48) according to the preceding claim, **characterised in that** the support shafts (44, 54) can be driven about the longitudinal axis thereof and **in that** shafts (7) of substrate plates (1, 42) according to Claim 3 are connected to the support shaft (44, 54) in a rotationally fixed manner.

9. The coating plant (40, 48) according to the preceding claim, **characterised in that** at least one of the substrate plates (1, 42) according to Claim 4 is formed on the support shaft (44, 54), wherein the support lever (16, 44) of the substrate plate (1, 42) is supported on a support rod (47, 55) running parallel to the support shaft (44, 54) and connected to the chamber bottom (41, 50).

## Revendications

1. Plaque de substrat (1, 19, 29, 30, 35, 36, 42) avec une pluralité de logements de substrat pour la fixation respectivement d'un substrat, chaque logement de substrat de la plaque de substrat (1, 19, 29, 30, 35, 36, 42) étant monté de manière rotative respectivement autour d'un axe de substrat (4) et avec un engrenage (8) qui présente un élément d'entraînement (9, 25, 46) excentrique et un élément de translation (10, 24) pouvant être guidé par l'élément d'entraînement (9, 25, 46) sur une voie circulaire autour d'un axe de plaque (6, 53) de la plaque de substrat (1, 19, 29, 30, 35, 36, 42) et qui entraîne les logements de substrat, **caractérisée en ce que** l'élément de translation (10, 24) est une roue dentée qui est en appui contre une pluralité de tourillons (12) s'étendant parallèlement à l'axe de plaque (6, 53) et reliés à la plaque de substrat (1, 19, 29, 30, 35, 36, 42), entraîne les logements de substrat via une roue solaire (14), et présente un alésage central (13) dans lequel coulisse un disque circulaire en guise d'élément d'entraînement (9, 25, 46) disposé de manière excentrique par rapport à l'axe de plaque (6, 53) de sorte que sur un arbre (7) de la plaque de substrat (1, 29, 35) s'étendant dans l'axe de plaque (6, 53), une autre plaque de substrat (1, 30, 36) peut être en appui de manière à pouvoir guider une charge de l'autre plaque de substrat (1, 30, 36) via l'arbre (7) à travers l'engrenage (8) et la plaque de substrat (1, 29, 35).

2. Plaque de substrat selon la revendication précédente, **caractérisée en ce que** les axes de substrat sont inclinés par rapport à l'axe de plaque.

3. Plaque de substrat (1, 19, 29, 30, 35, 36, 42) selon l'une des revendications précédentes, **caractérisée en ce que** l'arbre (7) présente un élément d'ajustement pour la liaison solidaire en torsion avec un arbre de support (21, 39, 44, 54) d'une installation de revêtement (17, 31, 40, 48).

4. Plaque de substrat (1, 42) selon l'une des revendications précédentes, **caractérisée en ce que** l'élément d'entraînement (9, 46) est relié à un levier de support (16, 45) pointant radialement vers l'extérieur par-dessus les logements de substrat.

5. Plaque de substrat (1, 42) selon la revendication précédente, **caractérisée en ce que** le levier de support (16, 45) est relié en solidarité de torsion à l'élément d'entraînement (9, 46) seulement jusqu'à un moment de surcharge.

6. Plaque de substrat (1, 19, 29, 30, 35, 36, 42) selon l'une des revendications précédentes, **caractérisée par** un fourreau de protection (5, 20, 43) qui entoure latéralement la plaque de substrat (1, 19, 29, 30, 35, 36, 42), le fourreau de protection (5, 20, 43) présentant des alésages et les logements de substrat pénétrant le fourreau de protection (5, 20, 43) dans les alésages.

7. Installation de revêtement (17, 26, 31, 40, 48) pour le revêtement de substrats, avec un fond de chambre (18, 27, 38, 41, 50) et au moins un arbre de support (21, 39, 44, 54) disposé sur le fond de chambre (18, 27, 38, 41, 50) en symétrie de rotation autour d'un axe de l'installation de revêtement (17, 26, 31, 40, 48), au moins une première plaque de substrat (1, 19, 29, 30, 35, 36, 42) et une deuxième plaque de substrat (1, 30, 36) étant disposées sur au moins l'un des arbres de support (21, 39, 44, 54), **caractérisée en ce que** la première plaque de substrat (1, 29, 35) est réalisée selon l'une des revendications précédentes et **en ce que** la deuxième plaque de substrat (1, 30, 36) est en appui sur un arbre (7) de la première plaque de substrat (1, 29, 35) s'étendant dans l'axe de plaque (6, 53) de manière à ce qu'une charge de la deuxième plaque de substrat (1, 30, 36) soit guidée via l'arbre (7) à travers la première plaque de substrat (1, 29, 35) et son engrenage (8).

8. Installation de revêtement (40, 48) selon la revendication précédente, **caractérisée en ce que** les arbres de support (44, 54) peuvent être entraînés autour de leur axe longitudinal et **en ce que** des arbres (7) de plaques de substrat (1, 42) selon la revendication 3 sont reliés de manière solidaire en torsion à l'arbre de support (44, 54).

9. Installation de revêtement (40, 48) selon la revendication précédente, **caractérisée en ce que**, sur l'arbre de support (44, 54), au moins l'une des plaques de,substrat (1, 42) selon la revendication 4 est réalisée, le levier de support (16, 44) de la plaque de substrat (1, 42) étant en appui sur une tige de support (47, 55) s'étendant parallèlement à l'arbre de support (44, 54) et reliée au fond de chambre (41, 50).
